# FASCICULE DE BREVET EUROPEEN

(11) **EP 0 578 540 B1**
(45) Date de publication et mention de la délivrance du brevet: **28.02.1996**
(21) Numéro de dépôt: 93401697.3
(22) Date de dépôt: 30.06.1993
(51) Int. Cl.: G06F 11/26

(54) **Procédé pour tester le fonctionnement d'un circuit intégré spécialisé, et circuit intégré spécialisé s'y rapportant**
Verfahren zur Prüfung der Funktionsfähigkeit einer ASIC-Schaltung und darauf bezogene ASIC-Schaltung
Method of testing the functionality of an ASIC and related ASIC

(30) Priorité: 08.07.1992 FR 9208453
(43) Date de publication de la demande: 12.01.1994
(73) Titulaire: SGS-THOMSON MICROELECTRONICS S.A., F-94253 Gentilly Cédex (FR)
(72) Inventeur: Laborie, Jean-Louis, F-38120 Saint-Egreve (FR)
(74) Mandataire: Schmit, Christian Norbert Marie

(56) Documents cités:
- EP-A- 0 111 053
- PROCEEDINGS OF THE INTERNATIONAL TEST CONFERENCE 29-31 AOUT 1989 NEW YORK pages 615 - 623 , XP89992 W. HARWOOD 'TESTABILITY FEATURES OF THE MC68332 MODULAR MICROCONTROLLER'
- IEEE TRANSACTIONS ON INDUSTRIAL ELECTRONICS AND CONTROL INSTRUMENTATION vol. 36, no. 2, Mai 1989, NEW YORK pages 231 - 240 J-C LIEN ET AL 'A UNIVERSAL TEST AND MAINTENANCE CONTROLLER FOR MODULES AND BOARDS'
- PROCEEDINGS OF THE CUSTOM INTEGRATED CIRCUITS CONFERENCE, 15-18 MAI 1989 NEW YORK US pages 11.3.1 - 11.3.5 , XP75624 K.W. LANG ET AL 'A 16 Mbps adapter chip for IBM token-ring local area network'

## Description

La présente invention concerne un procédé pour tester le fonctionnement d'un circuit intégré spécialisé, ainsi qu'un circuit intégré spécialisé conçu pour la mise en oeuvre de ce procédé.

Les circuits intégrés spécialisés, ou ASIC (de l'anglais "Application Specific Integrated Circuit") sont des circuits intégrés réalisés sur une puce unique à la demande de l'utilisateur.

Certains circuits intégrés spécialisés comprennent une unité centrale (par exemple un processeur de traitement de signal, ou DSP, dans le cas d'un circuit intégré dédié au traitement de signal) associée à un certain nombre de dispositifs dépendants de l'application du circuit : mémoires, interfaces...

L'utilisateur fournit au fabricant le programme d'application du circuit et des informations sur la configuration de circuit souhaitée telles que le type et le volume des mémoires utiles ou la nature des dispositifs d'interface du circuit. Le circuit intégré est alors réalisé sur une puce en associant à l'unité centrale les dispositifs spécifiés, notamment une mémoire morte (ROM) contenant le programme d'application.

Une fois que la puce de silicium formant le circuit spécialisé a été fabriquée, différents tests doivent lui être appliqués pour vérifier son bon fonctionnement. Habituellement, le fabricant du circuit teste la constitution du circuit (caractéristiques des composants, connexions...) et l'utilisateur teste son programme d'application ou la manière avec laquelle le circuit l'exécute.

Pour le test du fabricant, il est connu de faire exécuter par l'unité centrale un programme de test automatique stocké dans la mémoire de programmes du circuit. On peut tester ainsi la constitution de l'unité centrale. On peut également tester ainsi la constitution de certains dispositifs associés à l'unité centrale, moyennant de connaître leurs caractéristiques : type, volume, format, forme d'onde des signaux... Or, dans le cas d'un circuit intégré spécialisé, on ne connaît ces caractéristiques qu'après avoir reçu la commande de l'utilisateur. Le nombre de configurations possibles du circuit étant très élevé, il n'est pas possible de prévoir un programme de test automatique pour chaque configuration demandée. On souhaite au contraire qu'un programme puisse tester des circuits ayant différentes configurations.

Pour tester des circuits intégrés, il est également connu, par exemple d'après le EP-A-0 358 376, d'utiliser un registre à décalage formé en reliant en série un ensemble de cellules élémentaires montées sur les lignes d'entrée/sortie du circuit intégré. Chaque cellule peut injecter sur sa ligne respective une valeur introduite en série à travers le registre à décalage, et échantillonner la valeur du signal véhiculé par cette ligne en vue d'une lecture en série à travers le registre à décalage. On peut ainsi injecter des signaux de test dans le circuit intégré et contrôler le comportement du circuit en réponse à ces signaux. Comme les cellules élémentaires sont montées au niveau des accès extérieurs du circuit intégré, elles ne donnent pas accès directement aux bus internes du circuit servant aux communications entre l'unité centrale et les dispositifs dépendants de l'application dans le cas d'un circuit intégré spécialisé. Cette méthode ne permet donc pas de tester distinctement l'unité centrale et les dispositifs dépendants de l'application, à moins d'augmenter considérablement le nombre de cellules élémentaires du registre à décalage, au détriment de la compacité du circuit intégré et de la rapidité du registre à décalage. L'introduction et la lecture en série des données à travers le registre à décalage sont des opérations lentes de sorte qu'il n'est pas possible en pratique de tester systématiquement le bon fonctionnement des dispositifs associés à l'unité centrale, notamment des mémoires qui peuvent contenir typiquement plusieurs centaines de milliers de bits.

Le document "PROCEEDINGS OF THE INTERNATIONAL TEST CONFERENCE" 29-31 août 1989, New-York, US, pages 615 à 623 de W. HARWOOD, décrit la réalisation de fonctions destinées à assurer la testabilité du microcontrôleur MC 68 332. Le test en question n'utilise pas de registre à décalage connecté aux entrées/sorties de l'unité centrale, laquelle n'est pas utilisée pour le test des modules dudit microcontrôleur.

Au vu de ce qui précède, un but de la présente invention est de proposer un procédé pour tester le fonctionnement d'un circuit intégré qui soit bien adapté au cas des circuits intégrés spécialisés et qui permette notamment au fabricant de tester à la fois la constitution de l'unité centrale et celle des dispositifs dépendants de l'application.

Un autre but de l'invention est que le procédé procure des facilités pour tester le programme d'application du circuit intégré spécialisé.

L'invention propose ainsi un procédé pour tester le fonctionnement d'un circuit intégré spécialisé comprenant une unité centrale et des dispositifs dépendants de l'application du circuit intégré, reliés à l'unité centrale par des lignes d'accès, dans lequel on forme au moins un registre à décalage en reliant en série un ensemble de cellules élémentaires montées chacune sur une ligne respective véhiculant un signal binaire du circuit intégré, chaque cellule pouvant injecter sur ladite ligne une valeur introduite en série à travers le registre à décalage et pouvant échantillonner la valeur du signal binaire véhiculé par ladite ligne en vue d'une lecture de cette valeur à travers le registre à décalage, caractérisé en ce que les cellules élémentaires du registre à décalage sont montées sur des lignes correspondant à des accès de l'unité centrale aux-dits dispositifs et en ce qu'il inclut une procédure de test automatique de la constitution du circuit intégré comprenant les étapes suivantes :
- introduction à travers le registre à décalage de données caractéristiques des dispositifs dépendants de l'application reliés à l'unité centrale et mémorisation de ces données caractéristiques ;
- exécution par l'unité centrale d'un programme de test stocké dans une mémoire de programmes du circuit intégré, ce programme de test comportant au moins une instruction de lecture desdites données caractéristiques et une instruction de mémorisation de résultats de test ; et
- lecture des résultats de test mémorisés à travers le registre à décalage.

On peut ainsi, grâce à un registre à décalage qui conserve une structure et une organisation relativement simples, tester à la fois l'unité centrale et les dispositifs associés. Le registre peut réaliser ceci avec un nombre restreint de cellules élémentaires, certaines étant montées sur les bus internes du circuit reliant l'unité centrale aux dispositifs associés.

On observera que la réalisation des circuits intégrés spécialisés tire des avantages substantiels de la mise en oeuvre du procédé selon l'invention. En effet, pour rationaliser leur conception et leur fabrication, on souhaite habituellement que ces circuits soient conçus par assemblage d'unités quelque peu standardisées : unité centrale, unité(s) de mémoire, unité(s) d'interface..., ces unités pouvant être choisies par l'utilisateur parmi des "bibliothèques" proposées par le fabricant. Le montage classique de registre à décalage au niveau des bornes extérieures du circuit intégré global ne permet pas de standardiser la structure de ce registre qui dépendra toujours de la configuration particulière du circuit. Grâce à l'invention, ce registre peut être inclus dans une unité centrale standardisée utilisable avec un grand nombre de configurations de dispositifs associés. On évite donc, à chaque commande d'un circuit intégré spécialisé, une étape de conception et d'optimisation en surface du registre à décalage.

On peut alors tester de façon rapide la constitution du circuit en exécutant un programme de test qui reçoit certains paramètres de configuration par l'intermédiaire du registre à décalage, les résultats de ce programme étant également lus par le registre à décalage. L'exécution proprement dite du programme de test n'est pas retardée par des échanges de données en série à travers le registre à décalage, de sorte que la procédure permet de tester à la fois la logique du circuit et la vitesse d'exécution des instructions.

De préférence, le procédé selon l'invention inclut une procédure de test d'un programme d'application stocké dans une mémoire de programmes du circuit intégré, cette procédure comprenant les étapes suivantes :
- introduction à travers le registre à décalage d'une adresse de vérification, et mémorisation de cette adresse de vérification ;
- exécution du programme d'application jusqu'à l'instruction mémorisée à ladite adresse de vérification dans la mémoire de programmes ; et
- lecture à travers le registre à décalage de valeurs présentes sur des lignes d'accès de l'unité centrale.

L'utilisateur du circuit intégré peut ainsi tester son programme d'application et détecter commodément d'éventuelles améliorations à lui apporter (mode d'émulation).

L'adresse de vérification est avantageusement mémorisée dans des cellules élémentaires du registre à décalage montées sur des lignes d'un bus d'adresses d'instructions de l'unité centrale prévu pour repérer les emplacements de la mémoire de programmes contenant les instructions du programme d'application.

Ceci évite de prévoir une zone de mémoire servant uniquement au stockage de l'adresse de vérification.

Un second aspect de l'invention vise un circuit intégré spécialisé, comprenant une unité centrale, des dispositifs dépendants de l'application du circuit intégré reliés à l'unité centrale par des lignes d'accès, et au moins un registre à décalage comportant un ensemble de cellules élémentaires reliées en série et montées chacune sur une ligne respective véhiculant un signal binaire du circuit intégré, chaque cellule pouvant injecter sur ladite ligne une valeur introduite en série à travers le registre à décalage et pouvant échantillonner la valeur du signal binaire véhiculé par ladite ligne en vue d'une lecture de cette valeur à travers le registre à décalage, caractérisé en ce que les cellules élémentaires du registre à décalage sont montées sur des lignes correspondant à des lignes d'accès reliant l'unité centrale aux-dits dispositifs et en ce qu'il comprend
- des moyens d'introduction à travers le registre à décalage de données caractéristiques des dispositifs dépendants de l'application reliés à l'unité centrale et mémorisation de ces données caractéristiques,
- des moyens d'exécution par l'unité centrale d'un programme de test stocké dans une mémoire de programmes du circuit intégré, ce programme de test comportant au moins une instruction de lecture desdites données caractéristiques et une instruction de mémorisation de résultats de test ; et
- des moyens de lecture des résultats de test mémorisés à travers le registre à décalage.

Ce circuit est conçu pour la mise en oeuvre du procédé ci-dessus.

D'autres particularités et avantages de l'invention apparaîtront dans la description ci-après d'un exemple de réalisation préféré et non limitatif, lue conjointement aux dessins annexés, dans lesquels :
- la figure 1 est un schéma d'un circuit intégré spécialisé selon l'invention ;
- les figures 2 et 3 sont des schémas de cellules élémentaires d'un registre à décalage du circuit de la figure 1 ; et
- la figure 4 est un schéma d'une unité centrale du circuit de la figure 1.

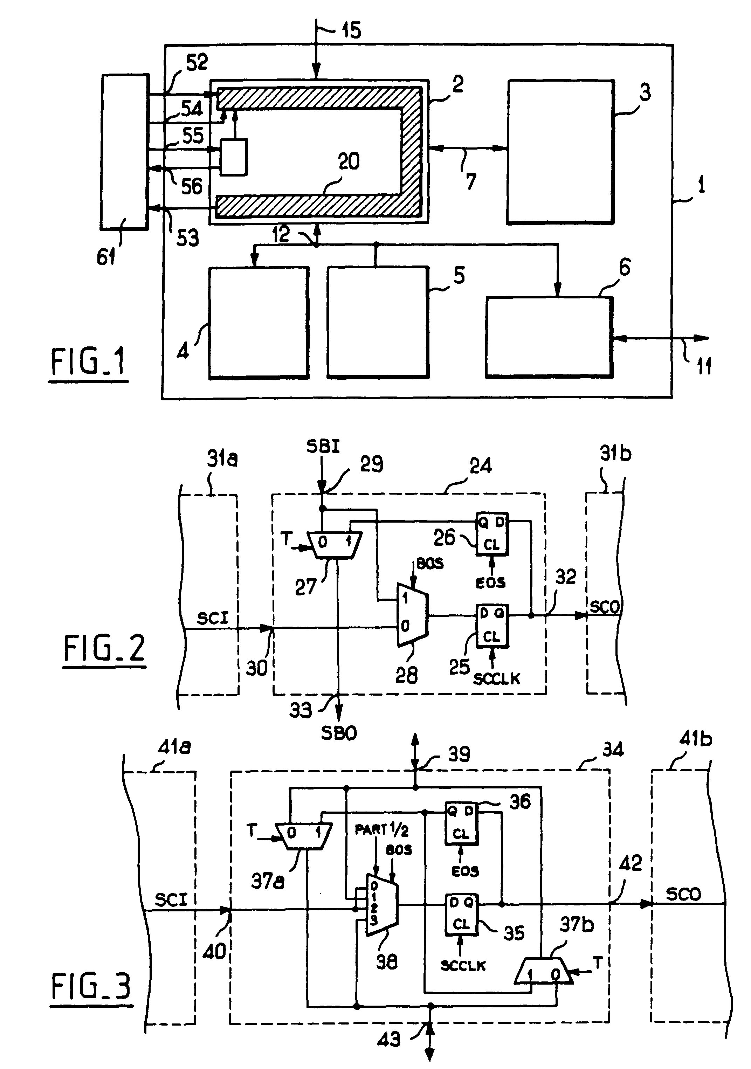

En référence à la figure 1, un circuit intégré 1 selon l'invention, réalisé sur une puce de silicium unique, comporte une unité centrale 2 et un certain nombre de dispositifs 3, 4, 5, 6 dépendants de l'application du circuit intégré. Dans l'exemple décrit, le circuit intégré 1 est dédié au traitement de signaux, et l'unité centrale 2 comporte les éléments essentiels d'un processeur de traitement de signal (DSP). Les dispositifs associés à l'unité centrale 2 comprennent une mémoire de programmes 3 à lecture seule (ROM), une mémoire de coefficients 4 à lecture seule (ROM), une mémoire de données 5 à accès direct (RAM) et un ou plusieurs dispositifs d'interface schématisés par l'unité 6 à la figure 1. Ces dispositifs d'interface sont reliés à des accès primaires 11 du circuit 1 permettant d'échanger des signaux analogiques ou numériques avec l'environnement du circuit 1.

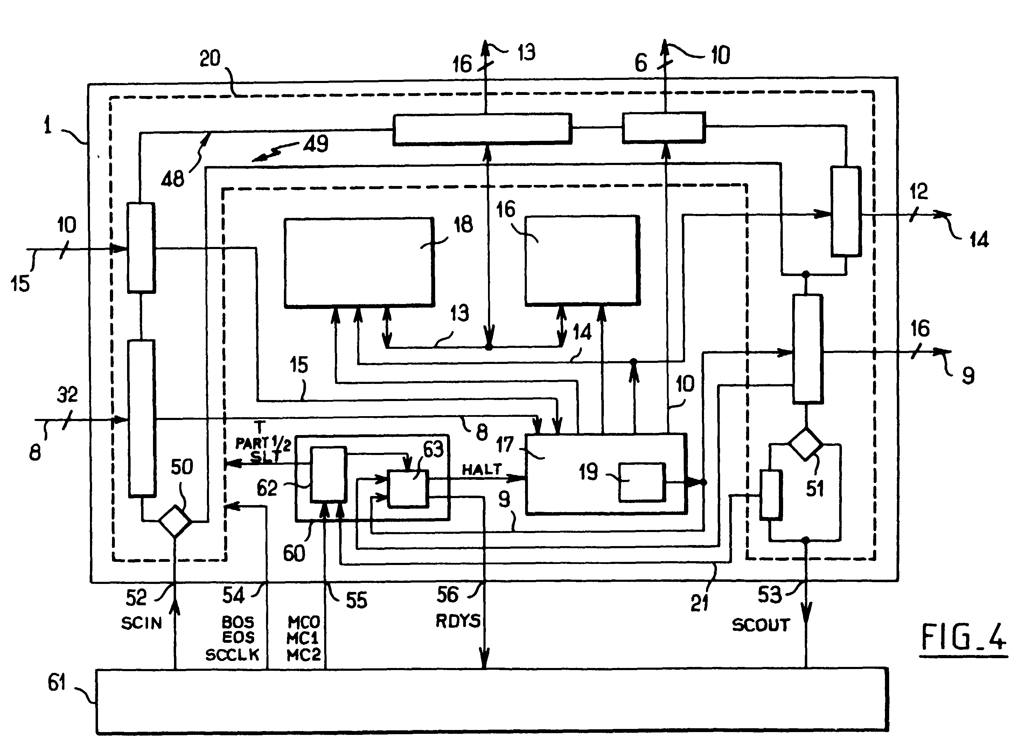

Les connexions 7 entre l'unité centrale et la mémoire de programmes 3 comprennent de façon classique, un bus d'instructions à 32 bits 8, un bus d'adresses d'instructions à 16 bits 9 et des lignes d'un bus de sortie de commandes à 6 bits 10 (figure 4) permettant à l'unité centrale 2 de lire des instructions de programme dans la mémoire 3 en vue de leur exécution.

De même, les connexions 12 entre l'unité centrale 2 et les dispositifs 4, 5, 6 comprennent un bus de données bidirectionnel à 16 bits 13, un bus d'adresses de données à 12 bits 14 et des lignes du bus de sortie de commandes à 6 bits 10 (figure 4) permettant à l'unité centrale 2 d'échanger des données (émission ou réception) avec les dispositifs 4, 5, 6.

L'unité centrale 2 comporte en outre un bus d'entrée de commandes à 10 bits 15 lui permettant de recevoir des signaux de commande extérieurs.

Comme représenté schématiquement à la figure 4, l'unité centrale 2 du circuit intégré spécialisé 1 comporte, de façon classique, une unité arithmétique 16, une unité de commande de programme 17 et quelques registres de mémoire à accès direct (RAM) 18. L'unité de commande de programme 17 comprend classiquement un séquenceur non représenté, des décodeurs non représentés recevant les instructions véhiculées sur le bus d'instructions 8 et les commandes reçues par l'unité centrale 2 sur le bus d'entrée de commandes 15 pour commander de façon appropriée l'unité arithmétique 16, un générateur d'adresses non représenté relié au bus d'adresses de données 14 pour produire des adresses repérant les emplacements de données dans la mémoire 18 ou les dispositifs associés 4, 5, 6, un générateur de commandes non représenté relié au bus de sortie de commande 10 et à la mémoire 18 pour commander des échanges de données avec les dispositifs associés 4, 5, 6 ou avec la mémoire 18, et un compteur de programme 19 relié au bus d'adresses d'instructions 9 pour produire des adresses repérant des instructions de programme dans la mémoire de programmes 3.

Conformément à l'invention, l'unité centrale 2 est munie d'un registre à décalage 20 dont la structure et le fonctionnement sont exposés ci-après. Ce registre à décalage 20, du type "boundary scan" (voir EP-A-0 358 376), comprend un ensemble de cellules élémentaires reliées en série et montées chacune sur une ligne respective véhiculant un signal binaire du circuit intégré 1. Plus précisément, les cellules élémentaires du registre à décalage sont montées sur des lignes correspondant à des accès de l'unité centrale 2 : bus d'instructions 8, bus d'entrée de commandes 15, bus de données 13, bus de sortie de commandes 10, bus d'adresses de données 14, bus d'adresses d'instructions 9, et lignes d'entrée de trois signaux de sélection 21 (figure 4).

Pour les lignes d'accès monodirectionnelles de l'unité centrale 2, on utilise des cellules élémentaires 24 du type représenté à la figure 2. Une telle cellule monodirectionnelle comprend une bascule à retard de type D 25, un circuit à verrouillage 26, un premier multiplexeur à deux entrées 27 et un second multiplexeur à deux entrées 28. Une entrée parallèle 29 de la cellule 24 reçoit le signal binaire SBI véhiculé par la ligne sur laquelle est montée la cellule 24. Cette entrée 29 est reliée à une entrée du premier multiplexeur 27 et à une entrée du second multiplexeur 28. Une entrée série 30 de la cellule 24 reçoit un signal binaire SCI issu de la cellule précédente 31a du registre à décalage 20. Cette entrée 30 est reliée à l'autre entrée du second multiplexeur 28. La sortie du second multiplexeur 28 est reliée à l'entrée D de la bascule à retard 25. La sortie Q de la bascule à retard 25 produit un signal binaire SCO qui est adressé à la cellule suivante 31b du registre à décalage par une sortie série 32 de la cellule. La sortie Q de la bascule 25 est en outre reliée à l'entrée D du circuit à verrouillage 26 dont la sorite Q est reliée à l'autre entrée du premier multiplexeur 27. La sortie du premier multiplexeur 27 est reliée à une sortie parallèle 33 de la cellule 24 qui transmet un signal binaire SBO sur la ligne comportant la cellule 24.

La cellule monodirectionnelle 24 reçoit quatre signaux de commande T, BOS, SCCLK, EOS. La valeur du signal binaire T commande le premier multiplexeur 27 : T = 0 correspond à la transmission sur la ligne du signal SBI (cellule transparente : SBO = SBI), tandis que T = 1 correspond à la transmission sur la ligne du signal mémorisé dans le circuit à verrouillage 26. La valeur du signal binaire BOS commande le second multiplexeur 28 : BOS = 0 fait communiquer l'entrée D de la bascule à retard 25 avec l'entrée série 30 de la cellule, tandis que BOS = 1 fait communiquer l'entrée D de la bascule à retard 25 avec l'entrée parallèle 29 de la cellule. Le signal binaire SCCLK est utilisé pour cadencer la bascule à retard 25. Le signal binaire EOS sert à verrouiller dans le circuit à verrouillage 26 la valeur présente à la sortie Q de la bascule D (verrouillage sur les fronts descendants de EOS par exemple).

Lorsqu'une cellule monodirectionnelle 24 est montée sur une ligne d'entrée de l'unité centrale 2 (bus 8 ou 15), son entrée parallèle 29 est raccordée à la partie de cette ligne dirigée vers l'extérieur de l'unité centrale 2, et sa sortie parallèle 33 est raccordée à la partie de cette ligne dirigée vers l'intérieur de l'unité centrale 2. Inversement, lorsqu'une cellule monodirectionnelle 24 est montée sur une ligne de sortie de l'unité centrale 2 (bus 10, 14 ou 9), son entrée parallèle 29 est raccordée à la partie de cette ligne dirigée vers l'intérieur de l'unité centrale 2, et sa sortie parallèle 33 est raccordée à la partie de cette ligne dirigée vers l'extérieur de l'unité centrale 2. Les lignes d'entrée de signaux de sélection 21 n'étant dirigées que vers l'intérieur de l'unité centrale 2, les cellules monodirectionnelles correspondantes 24 ont seulement leur sortie parallèle raccordée à ces lignes.

Pour les lignes d'accès bidirectionnelles de l'unité centrale 2, qui dans l'exemple représenté sont celles du bus de données 13, on utilise des cellules élémentaires 34 du type représenté à la figure 3. Une telle cellule bidirectionnelle comprend une bascule à retard de type D 35 cadencée par le signal d'horloge SCCLK, un circuit à verrouillage 36 commandé par le signal EOS, un premier multiplexeur à deux entrées 37a commandé par le signal T, un second multiplexeur à deux entrées 37b commandé par le signal T, et un troisième multiplexeur à quatre entrées 38 commandé par le signal BOS et par un autre signal binaire PART1/2. Une entrée/sortie parallèle 39 de la cellule 34 reliée à la ligne du bus de données est reliée à une entrée du premier multiplexeur 37a. Symétriquement, une entrée/sortie parallèle 43 de la cellule 34 reliée à la ligne du bus de données est reliée à une entrée du second multiplexeur 37b. Les deux autres entrées des premier et second multiplexeurs 37a, 37b sont reliées à la sortie Q du circuit à verrouillage 36. La sortie du premier multiplexeur 37a est reliée à l'entrée/sortie parallèle 43 de la cellule 34. La sortie du second multiplexeur 37b est reliée à l'entrée/sortie parallèle 39 de la cellule 34. Le troisième multiplexeur 38 a sa sortie reliée à l'entrée D de la bascule à retard 35. La sortie Q de la bascule à retard 35, qui produit le signal SCO délivré à la cellule suivante 41b du registre à décalage 20 par l'intermédiaire d'une sortie série 42 de la cellule, est en outre reliée à l'entrée D du circuit à verrouillage 36. Le troisième multiplexeur 38 a deux entrées reliées à une entrée série 40 de la cellule 34 recevant le signal binaire SCI issu de la cellule précédente 41a du registre à décalage 20, une entrée reliée à l'entrée/sortie parallèle 39 de la cellule 34, et une entrée reliée à l'entrée/sortie parallèle 43 de la cellule 34. Lorsque BOS = 0, le multiplexeur 38 fait communiquer l'entrée D de la bascule à retard 35 avec l'entrée série 40 de la cellule. Lorsque BOS = 1, le multiplexeur 38 fait communiquer l'entrée D de la bascule 35 avec
l'entrée/sortie parallèle 39 si PART1/2 = 0 ou avec
l'entrée/sortie parallèle 43 si PART1/2 = 1.

L'organisation des cellules élémentaires dans le registre à décalage 20 est illustrée à la figure 4. Le registre 20 comporte au moins deux trajets de décalage de données 48, 49. Un premier trajet 48 est formé entre des cellules élémentaires d'un groupe de cellules comprenant, dans cet ordre, les cellules élémentaires montées sur les lignes du bus d'instructions 8, du bus d'entrée de commandes 15, du bus de données 13, du bus de sortie de commandes 10, du bus d'adresses de données 14 et du bus d'adresses d'instructions 9 (32 + 10 + 16 + 6 + 12 + 16 = 92 cellules). Un deuxième trajet 49 est formé entre des cellules élémentaires d'un groupe de cellules comportant dans cet ordre les cellules élémentaires montées sur les lignes du bus d'adresses d'instructions 9 et les lignes d'entrée de signaux de sélection 21 (16 + 3 = 19 cellules).

Pour sélectionner le trajet de décalage de données utilisé, le registre à décalage 20 peut comporter deux commutateurs 50, 51 à deux positions. Dans une première position (utilisation du trajet 48), le premier commutateur 50 fait communiquer l'entrée de données 52 du registre 20 avec l'entrée série 30 de la première cellule élémentaire du bus d'instructions 8, et le second commutateur 51 fait communiquer directement la sortie série 32 de la dernière cellule élémentaire du bus d'adresses d'instructions 9 avec la sortie de données 53 du registre 20. Dans une seconde position, (utilisation du trajet 49), le premier commutateur 50 fait communiquer l'entrée de données 52 du registre 20 avec l'entrée série 30 de la première cellule élémentaire du bus d'adresses d'instructions 9, et le second commutateur 51 fait communiquer la sortie série 32 de la dernière cellule élémentaire du bus d'adresses d'instructions avec l'entrée série 30 de la première cellule élémentaire montée sur les lignes d'entrée de signaux de sélection 21. La position des commutateurs 50, 51 est commandée par un signal de sélection de trajet SLT issu d'un unité de commande de test 60.

Pour tester le circuit intégré 1, on le relie à un dispositif de test 61 (figures 1 et 4). Pour réaliser cette liaison, le circuit 1 comporte les bornes suivantes :
- borne 52 qui correspond à l'entrée de données série du registre à décalage 20 ;
- borne 53 qui correspond à la sortie de données série du registre à décalage 20 ;
- bornes désignées collectivement par la référence 54 pour adresser à l'ensemble des cellules élémentaires du registre à décalage 20 leurs signaux de commande BOS, EOS et SCCLK ;
- bornes désignées collectivement par la référence 55 pour adresser à l'unité de commande de test 60 trois signaux binaires de sélection MC0, MC1 et MC2 ; et
- borne de sortie 56 par laquelle l'unité de commande de test 60 peut adresser un signal de détection RDYS au dispositif de test 61.

L'unité de commande de test 60 comporte un sélecteur de mode 62 qui reçoit les trois signaux de sélection MC0, MC1, MC2 reçus aux bornes 55 et les trois signaux de sélection BP0, BP1, STE présents dans les cellules élémentaires montées sur les lignes 21, et qui établit, en fonction de ces six signaux de sélection, le signal de sélection de trajet SLT, le signal de commande PART1/2 destiné aux cellules bidirectionnelles 34 montées sur le bus de données 13, et les signaux de commande T destinés aux différentes cellules élémentaires du registre à décalage 20. Par exemple, le sélecteur de mode 62 peut produire les signaux indiqués au tableau I en fonction des signaux de sélection MC0, MC1, MC2, BP0, BP1, STE. Dans le tableau I, le symbole "X" indique que la valeur du bit correspondant est indifférente, la valeur SLT = 0 correspond à la sélection du premier trajet de décalage de données 48, et la valeur SLT = 1 correspond à la sélection du second trajet de décalage de données 49, le bit TID correspond au signal de commande T des cellules montées sur les lignes du bus d'instructions 8, le bit TCI correspond au signal de commande T des cellules montées sur les lignes du bus d'entrée de commandes 15, le bit TDR correspond au signal de commande T des cellules montées sur les lignes du bus de données 13, le bit TCA correspond au signal de commande T des cellules montées sur les lignes du bus de sortie de commandes 10 ou du bus d'adresses de données 14, et le bit TIA correspond au signal de commande T des cellules montées sur les lignes du bus d'adresses d'instructions 9. Le signal de commande T des trois cellules montées sur les lignes d'entrée de signaux de sélection 21 peut être pris constamment égal à 1 car ces cellules ne peuvent pas être transparentes.

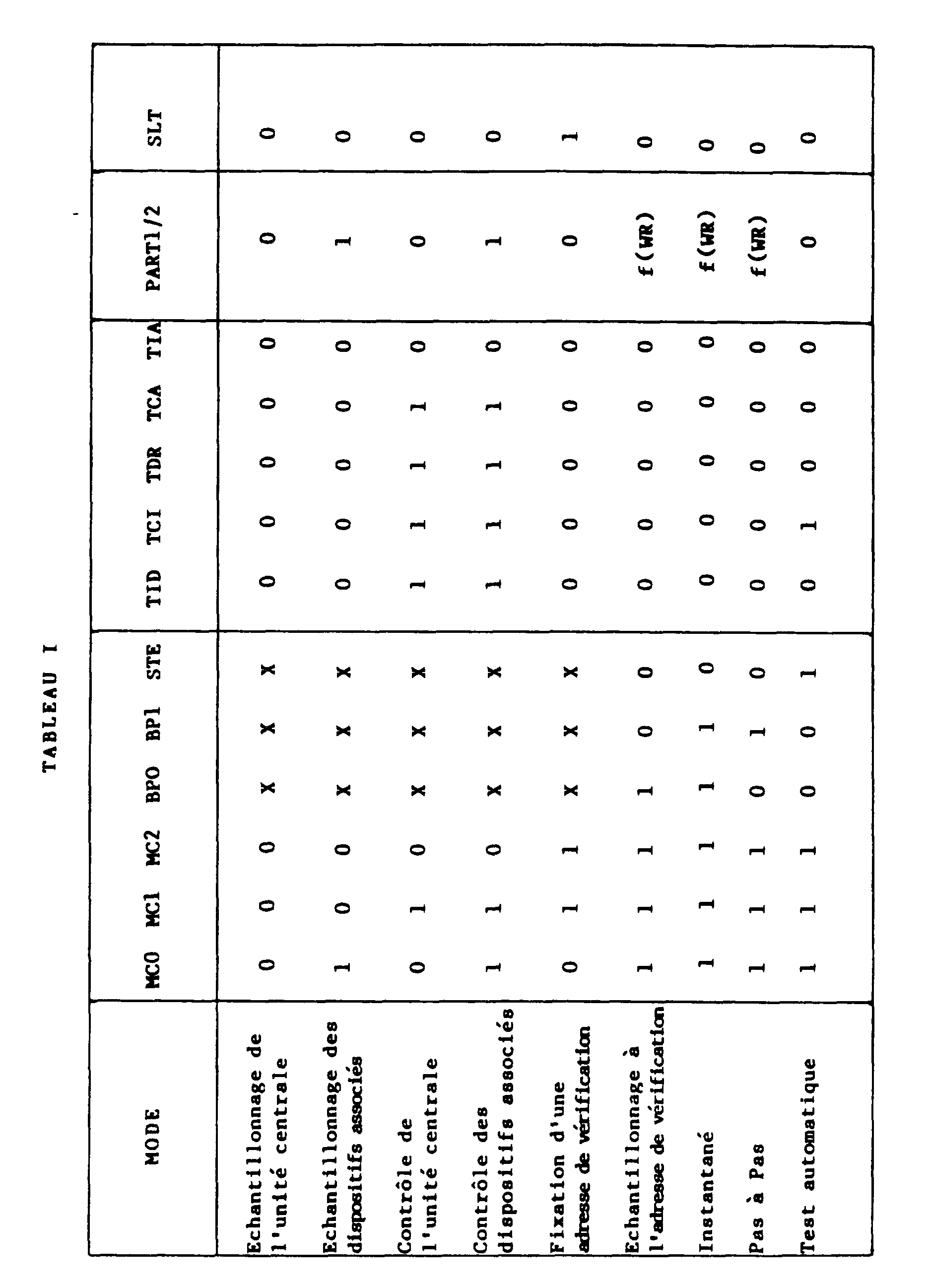

L'unité de commande de test 60 comprend en outre un comparateur 63 ayant deux entrées à 16 bits recevant respectivement l'adresse d'instruction générée par le compteur de programme 19 et le nombre de 16 bits correspondant aux 16 bits stockés dans les circuits à verrouillage 26 des cellules élémentaires montées sur les lignes du bus d'adresses d'instructions 9 (à cette fin, la sortie Q de chacun de ces 16 circuits à verrouillage est en outre reliée à l'entrée correspondante du comparateur 63). Le comparateur 63 active le signal de détection RDYS adressé au dispositif de test 61 par l'intermédiaire de la borne 56 lorsqu'il détecte une égalité entre ses deux entrées à 16 bits. Après l'activation du signal de détection RDYS, le comparateur 63 active en outre un signal d'interruption HALT qui est adressé au séquenceur de l'unité de commande de programme 17 pour interrompre le compteur de programme 19. La transmission du signal d'interruption HALT peut en outre être commandée par un signal fourni par le sélecteur de mode 62 au comparateur 63.

Les quatre premiers modes indiqués au tableau I correspondent à des modes de fonctionnement classiques d'un registre de type "boundary scan" :
a) Dans les deux modes d'échantillonnage, sélectionnés pour les valeurs indiquées des bits MC0, MC1, MC2, les cellules élémentaires du premier trajet 48 échantillonnent les valeurs des signaux binaires véhiculés par leurs lignes respectives, puis ces valeurs sont lues en série à travers le registre à décalage 20. L'échantillonnage est effectué en mettant le bit BOS au niveau 1 et en produisant un cycle d'horloge SCCLK, ce qui stocke la valeur échantillonnée dans la bascule 25, 35 (figures 2 et 3). Ensuite la lecture est effectuée en mettant le bit BOS au niveau 0 et en produisant des cycles d'horloge SCCLK, ce qui décale progressivement les valeurs stockées le long du trajet 48, de sorte que les données SCOUT parviennent en série à la sortie de données 53 du registre à décalage 20 et peuvent être lues par le dispositif de test 61. 50 (= 16 + 12 + 6 + 16) cycles d'horloge SCCLK sont ainsi nécessaires pour lire toutes les valeurs issues de l'unité centrale 2 en mode d'échantillonnage de l'unité centrale (PART1/2 = 0), tandis que 92 cycles d'horloge SCCLK sont nécessaires pour lire toutes les valeurs reçues par l'unité centrale 2 en mode d'échantillonnage des dispositifs associés (PART1/2 = 1). Ces deux modes d'échantillonnage n'interfèrent pas avec le fonctionnement du circuit 1 (signal d'interruption HALT désactivé).
b) Dans les deux modes de contrôle, sélectionnés par les valeurs indiquées des bits MC0, MC1, MC2, les cellules élémentaires du premier trajet 48 sont utilisées pour introduire des valeurs en série à travers le registre à décalage 20, puis pour injecter ces valeurs sur leurs lignes respectives. La réponse du circuit à l'injection de ces valeurs peut ensuite être échantillonnée et lue comme dans les modes d'échantillonnage. L'introduction est effectuée en mettant le bit BOS au niveau 0, en produisant des cycles d'horloge SCCLK, et en présentant les valeurs SCIN en série à la cadence de l'horloge SCCLK sur l'entrée de données 52 du registre à décalage 20. Une fois que les valeurs ont atteint les bascules 25, 35 des cellules appropriées, une impulsion du signal EOS verrouille ces données dans les circuits à verrouillage 26, 36. L'injection des valeurs résulte ensuite du passage au niveau 1 des signaux de commande T indiqués au tableau 1, qui commandent les multiplexeurs 27, 37a ou 37b pour faire communiquer la sortie Q des circuits à verrouillage 26, 36 avec les lignes respectives. Dans le mode de contrôle de l'unité centrale, on peut ainsi injecter des instructions à exécuter sur le bus d'instructions 8 et des données utiles à l'exécution de ces instructions sur le bus de données 13 : 58 (= 16 + 10 + 32) cycles d'horloge SCCLK sont utiles. La réponse de l'unité centrale 2 aux instructions injectées est ensuite échantillonnée et lue comme dans le mode d'échantillonnage de l'unité centrale, vers l'intérieur de l'unité centrale 2 en ce qui concerne le bus de données 13 (PART1/2 = 0). L'étape de lecture peut être effectuée en même temps que l'introduction en série d'autres valeurs par l'entrée de données 52. Le mode de contrôle des dispositifs associés diffère du mode de contrôle de l'unité centrale en ce que les réponses du circuit sont échantillonnées vers l'extérieur de l'unité centrale 2 pour les cellules bidirectionnelles montées sur le bus de données 13 (PART1/2 = 1). Ce mode de contrôle des dispositifs associés sert lorsque les instructions de contrôle injectées sur le bus d'instructions 8 sont des instructions de lecture dans des dispositifs associés à l'unité centrale, une adresse à 12 bits devant simultanément être injectée sur le bus d'adresses de données 14 : 76 (= 12 + 6 + 16 + 10 + 32) cycles d'horloge SCCLK sont nécessaires. Dans ces deux modes de contrôle, le compteur de programme 19 est interrompu (signal d'interruption HALT activé par le sélecteur de mode 62).

Le procédé selon l'invention inclut une procédure de test du programme d'application du circuit stocké dans la mémoire de programmes 3. Le programme d'application ayant été écrit par le fabricant du circuit intégré 1 dans la mémoire 3, le circuit 1 peut être livré à l'utilisateur avec un dispositif de test, ou outil d'émulation, 61 approprié pour effectuer la procédure de test du programme d'application.

Cette procédure comprend une étape initiale d'introduction à travers le registre à décalage 20 d'une adresse de vérification et de mémorisation de cette adresse de vérification. Cette étape initiale est effectuée en mode de fixation d'une adresse de vérification (tableau I) lorsque MC0 = 0, MC1 = MC2 = 1, ce qui sélectionne le second trajet 49 du registre à décalage 20 et interrompt le compteur de programme 19 (activation du signal d'interruption HALT forcée par le sélecteur de mode 62). L'adresse de vérification est introduite en même temps que les valeurs des trois bits de sélection BP0, BP1, STE en mettant le bit BOS au niveau 0, en produisant 19 cycles d'horloge SCCLK, et en présentant de façon synchrone sur l'entrée de données 52 du registre 20 les valeurs correspondant aux trois bits BP0, BP1, STE et à l'adresse de vérification (16 bits). Ces valeurs sont ensuite mémorisées dans les circuits à verrouillage 26 des cellules du second trajet 49 en produisant une impulsion du signal EOS. L'exécution du programme d'application est interrompue pendant cette étape du fait de l'interruption du compteur de programme 19.

Une fois que l'adresse de vérification a été introduite et mémorisée, l'application des signaux de sélection MC0 = MC1 = MC2 = 1 permet l'activation du mode de fonctionnement défini par les valeurs des bits BP0, BP1, STE (tableau I) qui correspondent à des signaux de sélection de modes d'exécution de la procédure de test du programme d'application.

La procédure de test du programme d'application comprend ensuite une exécution du programme d'application jusqu'à l'instruction mémorisée à l'adresse de vérification dans la mémoire de programme 3, puis une étape de lecture à travers le registre à décalage 20 de valeurs présentes sur des lignes d'accès de l'unité centrale 2. Ces deux étapes peuvent être effectuées soit en mode d'échantillonnage à l'adresse de vérification, soit en mode d'instantané (tableau I). Lorsque les signaux de sélection MC0, MC1, MC2 prennent la valeur 1, le sélecteur de mode 62 désactive le signal d'interruption HALT, de sorte que l'incrémentation du compteur de programme 19 reprend, et que les instructions du programme d'application sont exécutées successivement. Lorsque le compteur de programme 19 atteint l'adresse de vérification, le comparateur 63 active le signal de détection RDYS adressé au dispositif de test 61, ce qui déclenche l'étape de lecture. Cette étape de lecture est effectuée comme dans l'un des deux modes d'échantillonnage classiques du registre à décalage 20 : les données sont d'abord échantillonnées en mettant le signal BOS au niveau 1 et en produisant un cycle d'horloge SCCLK, puis elles sont lues en série en mettant le signal BOS au niveau 0 et en produisant 92 cycles d'horloge SCCLK, ce qui permet de récupérer les données sur la sortie SCOUT du registre à décalage 20.

Dans le tableau I, la notation f (WR) signifie qu'en mode d'échantillonnage à l'adresse de vérification ou en mode d'instantané (ou en mode pas à pas qui sera décrit plus loin), l'échantillonnage des valeurs véhiculées par le bus de données 13, défini par le bit PART1/2, est commandé par la valeur du signal de commande d'écriture WR résultant du décodage par l'unité de commande de programme 17 de l'instruction en cours et délivré sur le bus de sortie de commandes 10. Ceci permet l'observation de la donnée provenant de l'unité centrale 2 (PART1/2 = 0) lorsqu'une instruction d'écriture vers l'un des dispositifs associés 4, 5, 6 est exécutée, et l'observation de la donnée provenant d'un des dispositifs associés 4, 5, 6 (PART1/2 = 1) lorsqu'une instruction de lecture depuis ce dispositif est exécutée.

En mode d'instantané, l'étape de lecture est effectuée sans interrompre l'exécution du programme d'application : le sélecteur de mode 62 empêche la transmission du signal d'interruption HALT à l'unité de commande 17.

En mode d'échantillonnage à l'adresse de vérification, l'étape de lecture s'accompagne d'une interruption de l'exécution du programme d'application : le sélecteur de mode 62 autorise la transmission du signal d'interruption HALT à l'unité de commande de programme 17 après l'activation du signal de détection RDYS. Le signal HALT est activé avec un retard d'une période d'horloge de l'unité centrale 2 pour permettre à l'unité centrale 2 d'achever l'instruction en cours avant l'interruption. L'exécution du programme d'application restant interrompue, on peut ensuite lire le contenu des registres internes de l'unité centrale ou des emplacements des mémoires 4, 5, en plaçant le registre à décalage 20 en mode de contrôle de l'unité centrale ou en mode de contrôle des dispositifs associés. Ceci permet à l'utilisateur de vérifier comme il le souhaite la réponse du circuit intégré 1 au programme d'application.

Cette procédure de test du programme d'application, ou d'émulation, permet à l'utilisateur du circuit intégré spécialisé de détecter d'éventuelles erreurs de programmation ou des parties du programme pouvant être optimisées. Les données résultant de l'exécution du programme et lues à travers le registre 20 peuvent être comparées à des données de référence que l'utilisateur connaît par des simulations antérieures. Lorsqu'une erreur a été détectée pour l'une des instructions du programme d'application, l'invention permet à l'utilisateur de continuer le test de son programme malgré l'existence de cette erreur : il fixe une adresse de vérification correspondant à l'adresse de l'instruction erronée, il poursuit la procédure de test du programme d'application en mode d'échantillonnage à l'adresse de vérification (avec interruption), il met le registre 20 en mode de contrôle de l'unité centrale ou en mode de contrôle des dispositifs associés en introduisant une instruction appropriée pour corriger les effets produits par l'instruction erronée, et il reprend la procédure de test du programme d'application après avoir éventuellement défini une nouvelle adresse de vérification.

L'utilisateur dispose donc d'une grande richesse fonctionnelle pour vérifier le bon fonctionnement de son programme d'application. Après avoir ainsi testé un spécimen du circuit intégré spécialisé, il peut effectuer une nouvelle commande au fabricant avec un programme d'application modifié.

L'invention permet également à l'utilisateur de tester son programme d'application en mode pas à pas (tableau I). Dans ce mode, les valeurs des signaux binaires véhiculés sur les lignes d'accès de l'unité centrale 2 sont échantillonnées et lues après chaque instruction du programme d'application. Le sélecteur de mode 62 commande alors le comparateur 63 pour qu'il active le signal de détection RDYS et le signal d'interruption HALT après chaque changement de l'adresse délivrée par le compteur de programme 19 (l'interruption est nécessaire pour avoir le temps de lire les données en série à travers le registre à décalage 20).

Le procédé selon l'invention inclut en outre une procédure de test automatique de la constitution du circuit intégré. Cette procédure sera généralement appliquée par le fabricant du circuit intégré spécialisé 1 avant de le livrer à l'utilisateur au moyen d'un dispositif de test approprié 61. Cette procédure ne comprend aucune vérification du programme d'application de l'utilisateur. Elle comprend une exécution par l'unité centrale 2 d'un programme de test stocké à partir d'une adresse prédéterminée dans la mémoire de programmes 3. Ce programme de test n'est pas propre à la configuration des dispositifs associés à l'unité centrale, ce qui permet d'utiliser ce même programme dans toute une famille de circuits intégrés spécialisés construits autour d'un type d'unité centrale 2.

Pour que ce programme de test puisse tester à la fois l'unité centrale 2 et les dispositifs associés dépendants de l'application 3, 4, 5, 6, la procédure de test de la constitution du circuit comprend une étape initiale d'introduction à travers le registre à décalage 20 de données caractéristiques des dispositifs associés 3, 4, 5, 6 et de mémorisation de ces données caractéristiques. Les données caractéristiques comprennent typiquement le nombre et la nature des dispositifs associés, la forme d'onde de leurs signaux de commande, la longueur des mots de données échangés, les temps d'accès, le nombre d'emplacements (volume) des mémoires 3, 4, 5, les adresses des premiers emplacements des mémoires 3, 4, 5...

Cette étape d'introduction et de mémorisation des données caractéristiques est effectuée au moyen du registre à décalage 20 dans le mode de contrôle de l'unité centrale 2 : on commande les cellules élémentaires du registre 20 de façon à injecter sur le bus de données 13 les données caractéristiques à mémoriser et à injecter sur le bus d'instructions 8 une instruction d'écriture des données présente sur le bus de données 13 à un emplacement de la mémoire interne 18 repérée par son adresse. L'unité centrale 2 exécute ensuite cette instruction fournie sur le bus 8. Cette étape peut être répétée lorsque les données caractéristiques comportent plusieurs mots de 16 bits.

Une fois que les données caractéristiques ont été mémorisées, le dispositif de test 61 commande le sélecteur de mode 62 pour sélectionner le mode de test automatique (tableau I). Cette sélection s'effectue en deux étapes. On adresse d'abord des signaux de sélection MC0 = 0, MC1 = MC2 = 1 pour passer en mode de fixation d'une adresse de vérification pour pouvoir introduire dans les cellules montées sur les lignes 21 les valeurs BP0 = BP1 = 0, STE = 1 permettant de sélectionner ensuite le mode de test automatique. Ensuite, le mode de test automatique est validé en produisant les signaux de sélection MC0 = MC1 = MC2 = 1, ce qui désactive le signal d'interruption HALT, de sorte que l'exécution du programme de test peut démarrer. En mode de test automatique, le signal de commande TCI est mis au niveau 1 pour éviter que des commandes extérieures puissent interférer avec l'exécution du programme de test. Pendant que le registre 20 est en mode de fixation d'une adresse de vérification (compteur de programme 19 interrompu), on active un signal de réinitialisation adressé au circuit 1 par l'intermédiaire du bus d'entrée de commandes 15, ce qu'autorise le signal de commande TCI = 0. Lorsque le mode de test automatique est devenu actif (MC0 = MC1 = MC2 = 1), l'unité de commande de test 60 commande le compteur de programme 19 de façon que l'impulsion de réinitialisation place le compteur de programme 19 à l'adresse de la première instruction du programme de test automatique dans la mémoire 3 (en fonctionnement normal du circuit 1 une telle impulsion d'activation du signal de réinitialisation a pour effet de réinitialiser le compteur de programme 19 à l'adresse correspondant, dans la mémoire de programmes 3, à la première instruction du programme d'application).

Le programme de test comporte des instructions initiales de lecture des données caractéristiques stockées dans la mémoire interne 18, ce qui lui fournit les paramètres nécessaires pour effectuer des échanges de données avec les dispositifs associés. Il est particulièrement avantageux que le programme de test comporte ensuite des instructions d'échange de données (lecture ou écriture) entre l'unité centrale 2 et les dispositifs associés 3, 4, 5, 6. Comme le programme de test est d'une exécution relativement rapide, à la cadence de l'unité centrale 2, on peut ainsi envisager de tester un par un les différents emplacements des mémoires associées 4, 5 ou de tester des échanges de données pratiquement en temps réel avec les dispositifs d'interface 6.

Pour que l'exécution du programme de test soit rapide, on peut produire des résultats de test sous forme de signatures polynomiales calculées par un analyseur de signature non représenté monté sur un bus interne de l'unité centrale. Un exemple d'un tel analyseur de signature est décrit dans l'ouvrage "LSI/VLSI Testability Design" par Frank F.Tsui, Editions Mc Graw-Hill, 1988, Chapitre 7.

Le programme de test comporte enfin une instruction de mémorisation de ces résultats de test, qui consiste en une instruction d'écriture des résultats de test à un emplacement prédéterminé de la mémoire interne 18.

Après l'étape d'exécution du programme de test, la procédure de test automatique de la constitution du circuit intégré comprend une étape de lecture des résultats de test mémorisés à travers le registre à décalage 20. Cette étape de lecture des résultats est effectuée au moyen du registre 20 en mode de contrôle de l'unité centrale 2 : on commande les cellules élémentaires du registre 20 de façon à injecter sur le bus d'instructions 8 une instruction de lecture des résultats de test à leur emplacement dans la mémoire de données interne 18 et de présentation de ces résultats sur le bus de données 13. L'unité centrale 2 exécute ensuite cette instruction fournie sur le bus 8. Puis on commande les cellules élémentaires du registre 20 pour échantillonner la valeur de 16 bits présente sur le bus de données 13 (PART1/2 = 0) et pour lire cette valeur en série par la sortie de données 53 du registre 20.

Une fois que les résultats ont été lus par le dispositif de test 61, ils peuvent être comparés à des valeurs de référence connues ou acquises par simulation. Ceci permet de détecter d'éventuels défauts physiques (hardware) du circuit intégré spécialisé 1.

Bien qu'on ait décrit l'invention en référence à un exemple de réalisation préféré, on comprendra que cet exemple n'est pas limitatif et que diverses modifications peuvent lui être apportées sans sortir du cadre de l'invention.

## Revendications

1. Procédé pour tester le fonctionnement d'un circuit intégré spécialisé (1) comprenant une unité centrale (2) et des dispositifs (3, 4, 5, 6) dépendants de l'application du circuit intégré, reliés à l'unité centrale par des lignes d'accès (7,12), dans lequel on forme au moins un registre à décalage (20) en reliant en série un ensemble de cellules élémentaires montées chacune sur une ligne respective véhiculant un signal binaire du circuit intégré, chaque cellule pouvant injecter sur ladite ligne une valeur introduite en série (52) à travers le registre à décalage (20) et pouvant échantillonner la valeur du signal binaire véhiculé par ladite ligne en vue d'une lecture (53) de cette valeur à travers le registre à décalage (20), caractérisé en ce que les cellules élémentaires du registre à décalage (20) sont montées sur des lignes correspondant à des accès de l'unité centrale (2) aux-dits dispositifs et en ce qu'il inclut une procédure de test automatique de la constitution du circuit intégré (1) comprenant les étapes suivantes :
- introduction à travers le registre à décalage (20) de données caractéristiques des dispositifs (3, 4, 5, 6) dépendants de l'application reliés à l'unité centrale (2) et mémorisation de ces données caractéristiques ;
- exécution par l'unité centrale (2) d'un programme de test stocké dans une mémoire de programmes (3) du circuit intégré (2), ce programme de test comportant au moins une instruction de lecture desdites données caractéristiques et une instruction de mémorisation de résultats de test ; et
- lecture des résultats de test mémorisés à travers le registre à décalage (20).

2. Procédé conforme à la revendication 1, caractérisé en ce que le programme de test comporte des instructions d'échange de données entre l'unité centrale (2) et les dispositifs (3, 4, 5, 6) dépendant de l'application.

3. Procédé conforme à l'une des revendications 1 ou 2, caractérisé en ce que lesdites données caractéristiques et lesdits résultats de test sont mémorisés dans une mémoire interne (18) de l'unité centrale (2).

4. Procédé conforme à l'une des revendications 1 à 3, caractérisé en ce que le registre à décalage (20) comprend des cellules élémentaires respectivement montées sur des lignes d'un bus de données (13) et d'un bus d'instructions (8) de l'unité centrale (2), et en ce que l'étape d'introduction et de mémorisation des données caractéristiques est effectuée en commandant les cellules élémentaires du registre à décalage (20) de façon à injecter sur le bus de données (13) des données caractéristiques et à injecter sur le bus d'instructions (8) une instruction d'écriture des données présentes sur le bus de données (13) à un emplacement de mémoire, et en exécutant l'instruction présente sur le bus d'instructions (8).

5. Procédé conforme à la revendication 4, caractérisé en ce que l'étape de lecture des résultats de test mémorisés est effectuée en commandant les cellules élémentaires du registre à décalage (20) de façon à injecter sur le bus d'instructions (8) une instruction de lecture des résultats de test et de présentation de ces résultats de test sur le bus de données (13), en exécutant l'instruction présente sur le bus de données d'instructions (8), et en commandant les cellules élémentaires du registre à décalage (20) de façon à échantillonner la valeur présente sur le bus de données (13) et à lire la valeur échantillonnée à travers le registre à décalage (20).

6. Procédé conforme à l'une des revendications 1 à 5, caractérisé en ce qu'il inclut une procédure de test d'un programme d'application stocké dans une mémoire de programmes (3) du circuit intégré (1), cette procédure comprenant les étapes suivantes :
- introduction à travers le registre à décalage (20) d'une adresse de vérification, et mémorisation de cette adresse de vérification ;
- exécution du programme d'application jusqu'à l'instruction mémorisée à ladite adresse de vérification dans la mémoire de programmes (3) ; et
- lecture à travers le registre à décalage (20) de valeurs présentes sur des lignes d'accès à l'unité centrale (2).

7. Procédé conforme à la revendication 6, caractérisé en ce que l'exécution du programme d'application est interrompue lorsqu'il atteint l'instruction mémorisée à l'adresse de vérification dans la mémoire de programmes (3).

8. Procédé conforme à l'une des revendications 6 ou 7, caractérisé en ce que l'adresse de vérification est mémorisée dans des cellules élémentaires du registre à décalage (20) montées sur des lignes d'un bus d'adresses d'instructions (9) de l'unité centrale (2) prévu pour repérer les emplacements de la mémoire de programmes (3) contenant les instructions du programme d'application.

9. Procédé conforme à la revendication 8, caractérisé en ce que les cellules élémentaires montées sur les lignes du bus d'adresses d'instructions (9) comportent une sortie reliée à l'entrée d'un comparateur (63) ayant une autre entrée reliée à un compteur de programme (19) de l'unité centrale (2), le comparateur (63) activant un signal de détection (RDYS) lorsque l'adresse fournie par le compteur de programme (19) est égale à l'adresse de vérification.

10. Procédé conforme à l'une des revendications 8 ou 9, caractérisé en ce que le registre à décalage (20) comporte au moins deux trajets de décalage de données (48, 49), un premier trajet de décalage de données (48) étant formé entre des cellules élémentaires d'un premier groupe comprenant des cellules élémentaires montées respectivement sur des lignes d'un bus de données (13), d'un bus d'adresses de données (14), d'un bus d'instructions (8), du bus d'adresses d'instructions (9), d'un bus d'entrée de commandes (15) et d'un bus de sortie de commandes (10) de l'unité centrale (2), un second trajet de décalage de données (49) étant formé entre des cellules élémentaires d'un second groupe comprenant des cellules élémentaires montées sur des lignes du bus d'adresses d'instructions (9) de l'unité centrale (2), et en ce que l'étape d'introduction de l'adresse de vérification est effectuée en série suivant ledit second trajet de décalage de données (49).

11. Procédé conforme à la revendication 10, caractérisé en ce que le second trajet de décalage de données (49) comporte en outre des cellules élémentaires montées sur des lignes d'accès (21) de l'unité centrale (2) servant à véhiculer des signaux (BP0, BP1, STE) de sélection de modes d'exécution de la procédure de test du programme d'application.

12. Procédé conforme à l'une des revendications 10 ou 11, caractérisé en ce que l'étape d'introduction de l'adresse de vérification suivant le second trajet de décalage de données (49) est effectuée pendant une interruption de l'exécution du programme d'application.

13. Circuit intégré spécialisé (1), comprenant une unité centrale (2), des dispositifs (3, 4, 5, 6) dépendants de l'application du circuit intégré reliés à l'unité centrale par des lignes d'accès (7,12), et au moins un registre à décalage (20) comportant un ensemble de cellules élémentaires reliées en série et montées chacune sur une ligne respective véhiculant un signal binaire du circuit intégré, chaque cellule pouvant injecter sur ladite ligne une valeur introduite en série (52) à travers le registre à décalage (20) et pouvant échantillonner la valeur du signal binaire véhiculé par ladite ligne en vue d'une lecture (53) de cette valeur à travers le registre à décalage (20), caractérisé en ce que les cellules élémentaires du registre à décalage (20) sont montées sur des lignes correspondant à des lignes d'accès reliant l'unité centrale (2) aux-dits dispositifs et en ce qu'il comprend
- des moyens d'introduction à travers le registre à décalage (20) de données caractéristiques des dispositifs (3, 4, 5, 6) dépendants de l'application reliés à l'unité centrale (2) et mémorisation de ces données caractéristiques;
- des moyens d'exécution par l'unité centrale (2) d'un programme de test stocké dans une mémoire de programmes (3) du circuit intégré (2), ce programme de test comportant au moins une instruction de lecture desdites données caractéristiques et une instruction de mémorisation de résultats de test ; et
- des moyens de lecture des résultats de test mémorisés à travers le registre à décalage (20).

14. Circuit intégré spécialisé conforme à la revendication 13, caractérisé en ce que le registre à décalage (20) comporte des cellules élémentaires montées sur des lignes d'un bus d'adresses d'instructions (9) de l'unité centrale (2) pour mémoriser une adresse de vérification pouvant être introduite en série à travers le registre à décalage (20), en ce que l'unité centrale (2) comprend un compteur de programme (19) pour délivrer sur le bus d'adresses d'instructions (9) des adresses d'emplacements d'une mémoire de programmes (3) contenant un programme d'application, et en ce que l'unité centrale (2) comprend en outre un comparateur (63) ayant une entrée reliée au compteur de programme (19) et une entrée reliée aux cellules élémentaires montées sur les lignes du bus d'adresses d'instructions (9), le comparateur (63) étant agencé pour activer un signal de détection (RDYS) lorsque l'adresse fournie par le compteur de programme (19) est égale à ladite adresse de vérification.

15. Circuit intégré spécialisé conforme à la revendication 14, caractérisé en ce que le comparateur (63) est en outre agencé pour activer un signal d'interruption (HALT) retardé par rapport au signal de détection (RDYS) pour interrompre l'exécution du programme d'application lorsqu'il atteint l'instruction mémorisée à l'adresse de vérification dans la mémoire de programmes (3).

16. Circuit intégré spécialisé conforme à l'une des revendications 14 ou 15, caractérisé en ce que le registre à décalage (20) comporte au moins deux trajets de décalage de données (48, 49) un premier trajet de décalage de données (48) étant formé entre des cellules élémentaires d'un premier groupe comprenant des cellules élémentaires montées respectivement sur des lignes d'un bus de données (13), d'un bus d'adresses de données (14), d'un bus d'instructions (8), du bus d'adresses d'instructions (9), d'un bus d'entrée de commandes (15) et d'un bus de sortie de commandes (10) de l'unité centrale (2), un second trajet de décalage de données (49) étant formé entre des cellules élémentaires d'un second groupe comprenant des cellules élémentaires montées sur des lignes du bus d'adresses d'instructions (9) de l'unité centrale (2).

## Patentansprüche

1. Verfahren zur Funktionsprfung einer anwenderspezifschen integrierten Schaltung (1) mit einer Zentraleinheit (2) und von der Anwendung der integrierten Schaltung abhängige Vorrichtungen (3, 4, 5, 6), die mit der Zentraleinheit durch Zugriffsleitungen (7, 12) verbunden sind, wobei in der integrierten Schaltung zumindest ein in Serie mit einem Satz von Elementarzellen verbundenes Schieberegister (20) gebildet ist, die jeweils auf einer entsprechenden Leitung montiert sind, welche ein Binärsignal zu der integrierten Schaltung übertragen, jede Zelle kann auf die besagte Leitung einen seriell eingebrachten Wert (52) über das Schieberegister (20) ausgeben und kann weiterhin den wert des durch die besagle Leitung übertragenen Binärsignals aufgrund eines Lesens (53) dieses Werts über das Schieberegister (20) abfragen, dadurch gekennzeichnet, daß die Elementarzellen des Schieberegisters (20) auf Leitungen montiert sind, die den Zugriffen der Zentraleinheit (2) auf die besagten Vorrichtungen entsprechen und daß ein Verfahren zum automatischen Testen der Beschaffenheit der integrierten Schaltung (1) mit den folgenden Schritten enthalten ist:
- Zuführen von für die Vorrichtungen (3, 4, 5, 6) charakteristischen Daten über das Schieberegister (20) abhängig von der mit der Zentraleinheit (2) verbundenen Anwendung und Speichern dieser charakteristischen Daten;
- Ausführen eines Testprogramms, gespeichert in einem Programmspeicher (3) der integrierten Schaltung (2) durch die Zentraleinheit (2), wobei das Testprogramm zumindest eine Leseanweisung der charakteristischen Daten und eine Speicheranweisung der Testresultate enthält, und
- Lesen der gespeicherten Testresultate über das Schieberegister (20).

2. Verfahren nach Anspruch 1, dadurch gekennzeichnet, daß das Testprogramm Austauschanweisungen für Daten zwischen der Zentraleinheit (2) und den Vorrichtungen (3, 4, 5, 6) abhängig von der Anwendung enthält.

3. Verfahren nach einem der Ansprüche 1 oder 2, dadurch gekennzeichnet, daß die charakteristischen Daten und die Testergebnisse in einem internen Speicher (18) der Zentraleinheit (2) gespeichert sind.

4. Verfahren nach einem der Ansprüche 1-3, dadurch gekennzeichnet, daß das Schieberegister (20) Elementarzellen enthält, die jeweils auf den Leitungen eines Datenbusses (13) und eines Anweisungsbusses (8) der Zentraleinheit (2) montiert sind und daß der Zuführschritt und der Speicherschritt der charakteiristischen Daten einen Befehl für die Elementarzellen des Schieberegisters (20) hin durchgeführt werden, und zwar durch ein Ausgeben von charakteristischen Daten auf den Datenbus (13) und ein Ausgeben auf den Anweisungsbus (8) einer Leseanweisung für die auf dem Datenbus (13) vorhandenen Daten an einer Speicherstelle und durch ein Ausführen der vorhandenen Anweisung auf dem Anweisungsbus (8).

5. Verfahren nach Anspruch 4, dadurch gekennzeichnet, daß der Schritt des Lesens der gespeicherten Testergebnisse auf einen Befehl für die Elementarzellen des Schieberegisters hin ausgeführt wird, und zwar durch ein Ausgeben einer Leseanweisung der Testergebnisse auf den Arweisungsbus (8) und durch das Vorsehen dieser Testergebnisse auf den Datenbus (13), und zwar durch eine Ausführung der Anweisung hin, die auf dem Anweisungsbus (8) vorhanden ist, und weiterhin durch einen Befehl für die Elementarzellen des Schieberegisters (20) zum Abfragen des auf dem Datenbus (13) vorhandenen Werts und zum Lesen des abgefragten Werts über das Schieberegister (20).

6. Verfahren nach einem der Ansprüche 1 bis 5, dadurch gekennzeichnet, daß ein Testverfahren eines Anwendungsprogramms enthalten ist, welches in einem Programmspeicher (3) der integrierten Schaltung (1) gespeichert ist, wobei dieses Verfahren die folgenden Schritte enthält:
- Zuführen einer Prüfadresse über das Schieberegister (20) und Speichern dieser Prüfadresse;
- Ausführen des Anwendungsprogramms bis zu der gespeicherten Anweisung an dieser Prüfadresse in dem Programmspeicher (3) und
- Lesen der über das Schieberegister (20) verlaufenden Werte, die auf den Zugriffsleitungen der Zentraleinheit (2) vorhanden sind.

7. Verfahren nach Anspruch 6, dadurch gekennzeichnet, daß die Ausführung des Anwendungsprogramms unterbrochen wird, wenn eine an der Prüfadresse gespeicherte Anweisung in dem Programmspeicher (3) erhalten wird.

8. Verfahren nach einem der Ansprüche 6 oder 7, dadurch gekennzeichnet, daß die Prüfadresse in den Elementarzellen des Schieberegisters (20) gespeichert ist, welche auf den Leitungen des Adreßänweisungsbusses (9) der Zentraleinheit (2) montiert sind und zum Kennzeichnen der Speicherstellen der Programme (3) vorgesehen sind, welche die Anweisungen der Anwendungsprogramme enthalten.

9. Verfahren nach Anspruch 8, dadurch gekennzeichnet, daß die auf den Leitungen des Anweisungsadreßbusses (9) montierten Elementarzellen einen Ausgang aufweisen, der mit dem Eingang eines Vergleichers (63) verbunden ist, welcher einen anderen Eingang aufweist, der mit einem Programmzähler (19) der Zentraleinheit (2) verbunden ist, wobei der Vergleicher (63) ein Erfassungssignal (RDYS) aktiviert, wenn die durch den Programmzähler (19) ausgegebene Adresse mit der Prüfadresse übereinstimmt.

10. Verfahren nach einem der Ansprüche 8 oder 9, dadurch gekennzeichnet, daß das Schieberegister (20) zumindest zwei Datenverschiebewege (48, 49) aufweist, wobei ein erster Datenverschiebeweg (48) zwischen den Elementarzellen einer ersten Gruppe ausgebildet ist, die die Elementarzellen enthält, welche jeweils auf den Leitungen eines Datenbusses (13) eines Adreßdatenbusses (14), eines Anweisungsbusses (8), des Adreßanweisungsbusses (9), eines Befehlseingabebusses (15) und eines Befehlausgangsbusses (10) der Zentraleinheit (2) montiert sind, wobei weiterhin ein zweiter Datenverschiebeweg (49) zwischen den Elementarzellen einer zweiten Gruppe ausgebildet ist, die die Elementarzellen enthält, welche auf den Leitugen des Adreßanweisungsbusses (9) der Zentraleinheit (2) montiert sind, und daß der Eingabeschritt der Prüfadressen seriell entlang dem zweiten Datenverschiebeweg (49) durchgeführt wird.

11. Verfahren nach Anspruch 10, dadurch gekennzeichnet, daß der zweite Datenverschiebeweg (49) außerdem Elementarzellen enthält, die auf den Zugriffsleitungen (21) der Zentraleinheit (2) montiert sind und zum Übertragen der Signale (BP0, BP1, STE) zur Auswahl von Ausführungsmodi des Verfahrens zum Testen der Anwendungsprogramme dienen.

12. Verfahren nach einem der Ansprüche 10 oder 11, dadurch gekennzeichnet, daß der Eingabeschritt der Prüfadressen entlang dem zweiten Datenverschiebeweg (49) während einer Unterbrechung der Anwendungsprogrammauführung durchgeführt wird.

13. Anwenderspezifische integrierte Schaltung (1) mit einer Zentraleinheit (2), von der Anwendung der Zentraleinheit abhängigen Vorrichtungen (3, 4, 5, 6), die mit der Zentraleinheit durch Zugriffsleitungen (7, 12) verbunden sind und zumindest einem Schieberegister (20) mit einer Gruppe von Elementarzellen, die in Serie verbunden sind und auf einer Leitung zur Übertragung eines Binärsignals der integrierten Schaltung montiert sind, wobei jede Zelle auf die besagte Leitung einen in Serie eingebrachten Wert (52) über das Schieberegister (20) ausgeben kann und den Wert des übertragenen Binärsignals über die besagte Leitung durch ein Lesen (53) dieses Werts ausgeben kann, und zwar über das Schieberegister (20), dadurch gekennzeichnet, daß die Elementarzellen des Schieberegisters auf Leitungen montiert sind, die den mit der Zentraleinheit (2) verbundenen Zugriffsleitungen auf die besagten Vorrichtungen entsprechen, daß
- Mittel zum Zuführen von charakteristischen Daten der mit der Zentraleinheit (2) verbundenen Vorrichtungen (3, 4, 5, 6) abhängig von der Anwendung vorgesehen sind und zum Speichern dieser charakteristischen Daten,
- Mittel zum Ausführen eines Testprogrammes durch die Zentraleinheit (2) vorgesehen sind, wobei das Testprogramm in einem Programmspeicher (3) der integrierten Schaltung (2) gespeichert ist und das Testprogramm zumindest eine Leseanweisung der charakteristischen Daten und eine Speicheranweisung der Testergebnisse enthält und
- Lesemittel der Testergebnisse vorgesehen sind, welche über das Schieberegister (20) gespeichert werden.

14. Anwenderspezifische integrierte Schaltung nach Anspruch 13, dadurch gekennzeichnet, daß das Schieberegister (20) Elementarzellen enthält, die auf den Leitungen eines Adreßanweisungsbusses (9) der Zentraleinheit (2) zum Speichern einer Prüfadresse montiert sind, die seriell durch das Schieberegister (20) eingebracht werden kann, daß die Zentraleinheit (2) einen Programmzähler (19) enthält, zum Zuführen von Adreßstellen eines; Programmspeichers (3) zum Adreßanweisungsbus (9), wobei der Programmspeicher (3) ein Anwendungsprogramm enthält und daß die Zentraleinheit (2) außerdem einen vergleicher (63) enthält, der einen Eingang aufweist, welcher mit dem Programmzähler (19) verbunden ist und weiterhin einen Eingang aufweist, der mit den Elementarzellen verbunden ist, die auf den Leitungen des Adreßanweisungsbusses (9) montiert sind, wobei der Vergleicher (63) zum Aktivieren eines Erfassungssignals (RDYS) angeordnet ist, wenn die durch den Programmzähler (19) abgegebene Adresse mit der Prüfadresse übereinstimmt,

15. Anwenderspezifische integrierte Schaltung nach Anspruch 14, dadurch gekennzeichnet daß der Vergleicher (63) außerdem zum Aktivieren eines Unterbrechnungssignals (HALT) angeordnet ist, welches im Verhältnis zum Erfassungssignal (RDYS) verzögert ist, zum Unterbrechen der Ausführung des Anwendungprogramms, wenn die Speicheranweisung an der Prüfadresse in dem Programmspeicher (3) erreicht ist.

16. Anwenderspezifische integrierte Schaltung nach einem der Ansprüche 14 oder 15, dadurch gekennzeichnet, daß das Schieberegister (20) zumindest zwei Datenverschiebewege (48, 49) enthält, wobei ein erster Datenverschiebeweg (48) zwischen den Elementarzellen einer ersten Gruppe gebildet ist, die die Elementarzellen enthält, welche jeweils auf den Leitungen des Datenbusses (13), eines Adreßdatenbusses (14), eines Anweisungsbusses (8), des Adreßanweisungsbusses (9), eines Befchlseingangsbusses (15) und eines Befehlsausgangsbusses (10) der Zentraleinheit (2) montiert sind, wobei ein zweiter Datenverschiebeweg (49) zwischen den Elementarzellen einer zweiten Gruppe gebildet ist, die die Elementarzellen enthält, welche auf den Leitungen des Adreßanweisungsbusses (9) der Zentraleinheit (2) montiert sind.

## Claims

1. Method for testing the functioning of a specialized integrated circuit (1) comprising a central unit (2) and devices (3, 4, 5, 6) dependant on the application of the integrated circuit, connected to the central unit by access lines (7, 12), in which at least one shift register (20) is formed by connecting in series a set of elementary cells each mounted on a respective line carrying a binary signal of the integrated circuit, each cell being capable of injecting on the said line a value introduced in series (52) through the shift register (20) and capable of sampling the value of the binary signal carried by the said line so that this value can be read (53) through the shift register (20), characterized in that the elementary cells of the shift register (20) are mounted on lines corresponding to accesses of the central unit (2) to the said devices and in that it includes an automatic procedure for testing the constitution of the integrated circuit (1) comprising the following steps:
- introducing through the shift register (20) data characteristic of the devices (3, 4, 5, 6) which are dependant on the application and are connected to the central unit (2), and storing these characteristic data;
- the running by the central unit (2) of a test program stored in a program memory (3) of the integrated circuit, this test program including at least one instruction for reading the said characteristic data and a test result storage instruction; and
- reading of the test results stored through the shift register (20).

2. Method according to Claim 1, characterized in that the test program includes instructions for data exchange between the central unit (2) and the devices (3, 4, 5, 6) dependant on the application.

3. Method according to one of Claims 1 or 2, characterized in that the said characteristic data and the said test results are stored in an internal memory (18) of the central unit (2).

4. Method according to one of Claims 1 to 3, characterized in that the shift register (20) comprises elementary cells respectively mounted on lines of a data bus (13) and instruction bus (8) of the central unit (2), and in that the step for the introduction and storage of the characteristic data is carried out by controlling the elementary cells in the shift register (20) so as to inject characteristic data on the data bus (13) and to inject on the instruction bus (8) an instruction to write the data that are on the data bus (13) to a memory location, and by carrying out the instruction that is on the instruction bus (8).

5. Method according to Claim 4, characterized in that the step of reading the stored test result is carried out by controlling the elementary cells in the shift register (20) so as to inject on the instruction bus (8) an instruction to read the test results and to present these test results on the data bus (13), by carrying out the instruction that is on the instruction data bus (8) and by controlling the elementary cells in the shift register (20) so as to sample the value that is on the data bus (13) and to read the value sampled through the shift register (20).

6. Method according to one of Claims 1 to 5, characterized in that it includes a procedure for testing an application program stored in a program memory (3) of the integrated circuit (1), this procedure comprising the following steps:
- introducing a check address through the shift register (20) and storing this check address;
- running the application program as far as the instruction stored at the said check address in the program memory (3); and
- reading values that are on access lines to the central unit (2) through the shift register (20).

7. Method according to Claim 6, characterized in that the running of the application program is interrupted when it reaches the instruction stored at the check address in the program memory (3).

8. Method according to one of Claims 6 or 7, characterized in that the check address is stored in elementary cells in the shift register (20) mounted on lines of an instruction address bus (9) of the central unit (2) intended to locate the program memory locations (3) containing the instructions for the application program.

9. Method according to Claim 8, characterized in that the elementary cells mounted on the lines of the instruction address bus (9) have an output connected to the input of a comparator (63) having another input connected to a program counter (19) in the central unit (2), the comparator (63) activating a detection signal (RDYS) when the address supplied by the program counter (19) is the same as the check address.

10. Method according to one of Claims 8 or 9, characterized in that the shift register (20) has at least two data shift paths (48, 49), a first data shift path (48) being formed between elementary cells of a first group comprising elementary cells mounted respectively on lines of a data bus (13), a data address bus (14), an instruction bus (8), the instruction address bus (9), a command input bus (15) and a command output bus (10) of the central unit, a second data shift path (49) being formed between elementary cells of a second group comprising elementary cells mounted on lines of the instruction address bus (9) of the central unit (2), and in that the step for introducing the check address is carried out in series along the said second data shift path (49).

11. Method according to Claim 10, characterized in that the second data shift path (49) also has elementary cells mounted on access lines (21) to the central unit (2) which serve to carry signals (BP0, BP1, STE) for selecting modes for carrying out the procedure for testing the application program.

12. Method according to one of Claims 10 or 11, characterized in that the step for introducing the check address along the second data shift path (49) is carried out during an interruption in the running of the application program.

13. Specialized integrated circuit (1) comprising a central unit (2), devices (3, 4, 5, 6) which are dependant on the application of the integrated circuit and are connected to the central unit by access lines (7, 12), and at least one shift register (20) having a set of elementary cells connected in series and each mounted on a respective line carrying a binary signal of the integrated circuit, each cell being capable of injecting on the said line a value introduced in series (52) through the shift register (20) and being capable of sampling the value of the binary signal carried by the said line so that this value may be read (53) through the shift register (20), characterized in that the elementary cells of the shift register (20) are mounted on lines corresponding to access lines connecting the central unit (2) to the said devices and in that it comprises:
- means for introducing through the shift register (20) data characteristic of the devices (3, 4, 5, 6) which are dependant on the application and are connected to the central unit (2), and for storing these characteristic data;
- means for the central unit (2) to run a test program stored in a program memory (3) in the integrated circuit, this test program having at least a one instruction for reading the said characteristic data and one instruction for storing test results; and
- means for reading test results stored through the shift register (20).

14. Specialized integrated circuit according to Claim 13, characterized in that the shift register (20) has elementary cells mounted on lines of an instruction address bus (9) of the central unit (2) for storing a check address which can be introduced in series through the shift register (20), in that the central unit (2) comprises a program counter (19) for delivering on the instruction address bus (9) addresses of locations in a program memory (3) containing an application program, and in that the central unit (2) also comprises a comparator (63) having an input connected to the program counter (19) and an input connected to the elementary cells mounted on the lines of the instruction address bus (9), the comparator (63) being arranged so as to activate a detection signal (RDYS) when the address supplied by the program counter (19) is the same as the said check address.

15. Specialized integrated circuit according to Claim 14, characterized in that the comparator (63) is also arranged so as to activate an interrupt signal (HALT) delayed in relation to the detection signal (RDYS) in order to interrupt the running of the application program when it reaches the instruction stored at the check address in the program memory (3).

16. Specialized integrated circuit according to one of Claims 14 or 15, characterized in that the shift register (20) has at least two data shift paths (48, 49), a first data shift path (48) being formed between elementary cells in a first group comprising elementary cells mounted respectively on lines of a data bus (13), a data address bus (14), an instruction bus (8), the instruction address bus (9), a command input bus (15) and a command output bus (10) of the central unit, a second data shift path (49) being formed between elementary cells of a second group comprising elementary cells mounted on lines of the instruction address bus (9) of the central unit (2).
